# EUROPÄISCHE PATENTSCHRIFT

(11) **EP 2 246 707 B1**
(45) Veröffentlichungstag und Bekanntmachung des Hinweises auf die Patenterteilung: **07.10.2015**
(21) Anmeldenummer: 10004236.5
(22) Anmeldetag: 21.04.2010
(51) Int. Cl.: G01R 29/10

(54) **Verfahren und Anordnung zur Vermessung der Richtcharakteristik einer zu testenden Antenne**
Method and assembly for measuring the alignment characteristics of an antenna that is to be tested
Procédé et dispositif de mesure de la caractéristique de guidage d'une antenne devant être testée

(30) Priorität: 28.04.2009 DE 102009018925
(43) Veröffentlichungstag der Anmeldung: 03.11.2010
(73) Patentinhaber: Airbus DS GmbH, 82024 Taufkirchen (DE)
(72) Erfinder: Eibert, Thomas, 81925 München (DE); Schmidt, Carsten, 81243 München (DE); Fritzel, Torsten, 81925 München (DE); Steiner, Hans Jürgen, 81827 München (DE)
(74) Vertreter: Avenhaus, Beate

(56) Entgegenhaltungen:
- WO-A1-03/056349
- DE-A1- 19 807 208
- DE-A1-102004 037 718
- SCHIRRMACHER M ET AL: "RECHNERGESTUETZTES VERFAHREN FUER DIE BESTIMMUNG DER RICHTDIAGRAMMEVON ANTENNEN IN REFLEKTIERENDER UMGEBUNG" NACHRICHTENTECHNIK ELEKTRONIK, VEB VERLAG TECHNIK. BERLIN, DE, Bd. 43, Nr. 4, 1. Juli 1993 (1993-07-01), Seiten 191-196, XP000466095 ISSN: 0323-4657
- LAS-HERAS F ET AL: "Echo identification and cancellation techniques for antenna measurement in non-anechoic test sites" IEEE ANTENNAS AND PROPAGATION MAGAZINE, IEEE SERVICE CENTER, PISCATAWAY, NJ, US, Bd. 46, Nr. 1, 1. Februar 2004 (2004-02-01), Seiten 100-107, XP011112504 ISSN: 1045-9243
- POTTER M E ET AL: "Modeling of near-field sources in the finite-difference time-domain (FDTD)" AEROSPACE CONFERENCE, 2001, IEEE PROCEEDINGS. MAR. 10-17, 2001', PISCATAWAY, NJ, USA,IEEE, Bd. 2, 20. März 2001 (2001-03-20), Seiten 885-891, XP010548312 ISBN: 978-0-7803-6599-5

## Beschreibung

Die Erfindung betrifft ein Verfahren und eine Anordnung zur Vermessung der Richtcharakteristik einer zu testenden Antenne, nachfolgend als Testantenne bezeichnet.

Bei der Charakterisierung von elektromagnetischen Feldern tritt generell das Problem störender Feldbeiträge auf. Dieses Problem ergibt sich dadurch, dass die Überlagerung einer direkt von einer Antenne abgestrahlten Welle mit vom Erdboden gestreuten Wellenanteilen zum Teil zu erheblichen Messfehlern führt. Aufgrund des relativ großen Abstands (Messabstand) zwischen einer Messsonde und der zu vermessenden Testantenne ergibt sich ein flacher Einfallswinkel der direkt erzeugten Welle auf den Erdboden. Insbesondere tritt dieses Problem bei sog. Antennen-Fernfeldmessanlagen in Erscheinung. Dies hat zur Folge, dass das Richtdiagramm der Testantenne aufgrund der am Erdboden gestreuten Feldanteile nicht direkt messbar ist.

Zur Verbesserung des Messverfahrens ist man deshalb bestrebt, die am Boden gestreuten Anteile des Messsignals zu unterdrücken. Dies erfolgt beispielsweise dadurch, dass die Messsonde und die Testantenne zur Erzielung einer zeitlich möglichst langen Verzögerung des ausgestrahlten Signals bis zum Erfassen durch den Empfänger gegenüber dem Erdboden erhöht angeordnet werden. Die Unterdrückung der am Boden gestreuten Feldanteile erfolgt z.B. durch schnelle Schalter.

Alternativ ist ein sog. vertikales Probing der Messsonde bekannt, um die durch die Überlagerung des direkten und des gestreuten Signalanteils entstehende Welligkeit zu bestimmen und als Korrekturgröße pauschal in den gemessenen Antennendiagrammen zu berücksichtigen.

DE 198 07 208 A1, WO 03/056349 A1 und Schirrmacher et al. "Rechnergestütztes Verfahren für die Bestimmung der Richtdiagramme von Antennen in reflektierender Umgebung" effenbaren derartige Verfahren.

Eine weitere Methode zur Unterdrückung von am Boden gestreuten Feldanteilen besteht darin, möglichst unregelmäßige und absorbierende Streukörper entlang des Bodens zu platzieren, um spekular am Boden reflektierte Signalanteile zu verhindern.

Sämtliche aus dem Stand der Technik bekannten Vorgehensweisen sind jedoch nicht in der Lage, die Überlagerung des direkten Signalanteils mit dem vom Boden gestreuten Signalanteilen vollständig zu verhindern, so dass eine Messung weiterhin mit Fehlern behaftet ist. Insbesondere bei flachen Einfallswinkeln auf den Boden ist es kaum möglich, die gestreuten Feldanteile effektiv zu unterdrücken bzw. aus dem Messergebnis zu eliminieren.

Es ist daher Aufgabe der vorliegenden Erfindung, ein Verfahren und eine Anordnung zur Vermessung des Richtdiagramms einer Testantenne anzugeben, mit welchen auf einfache und genauere Weise die Bestimmung eines Richtdiagramms der Testantenne ermöglicht wird.

Diese Aufgaben werden gelöst durch ein Verfahren mit den Merkmalen des Patentanspruches 1 sowie eine Anordnung mit den Merkmalen des Patentanspruches 9. Vorteilhafte Ausgestaltungen ergeben sich aus den abhängigen Patentansprüchen.

Die Erfindung schafft ein Verfahren zur Vermessung des Richtdiagramms einer Testantenne. Bei diesem werden mehrere Messsonden relativ zu der Testantenne angeordnet. Die Testantenne wird in einer vorgegebenen Höhe über einer Bezugsebene, insbesondere einem Erdboden, angeordnet. In entsprechender Weise werden die mehreren Messsonden jeweils in einer vorgegebenen Höhe über der Bezugsebene angeordnet. Es wird zwischen allen Messsonden und der Testantenne eine Messung des Übertragungsverhaltens zur Testantenne vorgenommen. Hierbei erfolgt insbesondere eine Vermessung nach Betrag und Phase. Daraus wird das zur Messzeit vorherrschende Streuverhalten der Bezugsebene ermittelt und bei der Bestimmung des Richtdiagramms der Testantenne berücksichtigt.

Die Erfindung schafft ferner eine Anordnung zur Vermessung des Richtdiagramms einer Testantenne, umfassend mehrere Testsonden, die relativ zu der Testantenne angeordnet werden, wobei die Testantenne in einer vorgegebenen Höhe über einer Bezugsebene, insbesondere des Erdbodens, und die mehreren Messsonden jeweils in einer vorgegebenen Höhe über der Bezugsebene angeordnet sind. Die Anordnung umfasst ein Mittel, welches dazu ausgebildet ist, zwischen allen Messsonden und der Testantenne eine Messung des Übertragungsverhaltens zur Testantenne durchzuführen und die zur jeweiligen Messzeit vorherrschenden Streueigenschaften der Bezugsebene zu ermitteln und bei der Vermessung des Richtdiagramms der Testantenne zu berücksichtigen.

Die Verwendung mehrerer Messsonden, welche relativ zu der Testantenne angeordnet sind, ermöglicht die Anwendung eines parametrischen Modells, auf dessen Grundlage die Streufeldanteile minimiert bzw. unterdrückt werden können. Durch die Messung unter Verwendung von mehreren Messsonden lassen sich die zeitlich ändernden, jeweils vorherrschenden Streueigenschaften der Bezugsebene, in der Regel des Bodens, berücksichtigen. Dies ist insbesondere deshalb von Vorteil, da sich die Streueigenschaften erheblich und kurzfristig, z.B. durch Feuchte oder Vegetationsänderungen im Laufe eines Jahres, verändern können. Diese Eigenschaft unterscheidet das erfindungsgemäße Vorgehen von den aus dem Stand der Technik bekannten Vorgehen, welche insbesondere Änderungen des Bodens zur Eliminierung bzw. Unterdrückung der Streueigenschaften nicht berücksichtigen können.

Die an der Bezugsebene gestreuten Signalanteile werden hinsichtlich der Signalamplitude unterdrückt. Dazu umfasst die Anordnung ein entsprechendes Mittel, mit dem die am Boden gestreuten Signalanteile hinsichtlich der Signalamplitude unterdrückbar sind.

Gemäß einer weiteren Ausgestaltung werden zur rechnergestützten Ermittlung der Streueigenschaften (d.h. der störenden Signalanteile) der Bezugsebene als Repräsentant der Bezugsebene ein oder mehrere parasitäre Strahler mit jeweils unbekannter Strahlungsamplitude und Phase angenommen. In diesem Zusammenhang ist es zweckmäßig, wenn die Testantenne nicht wesentlich mit dem Boden verkoppelt ist. Dies bedeutet, die Testantenne ist ausreichend hoch und über der Bezugsebene anzubringen. Die genaue Höhe zwischen Bezugsebene und Testantenne kann hierbei durch den Fachmann mit einfachen Tests ausfindig gemacht werden. Insbesondere ist hierbei vorgesehen, dass die parasitären Strahler zwischen der Testantenne und den Messsonden verteilt angeordnet werden bzw. sind. Beispielsweise können die parasitären Strahler gleichverteilt zwischen der Testantenne und den Messsonden angeordnet sein.

In einer zweckmäßigen Ausgestaltung werden durch n+1 Messsonden n+1 linear unabhängige Messwerte aufgenommen, wobei n die Anzahl der angenommenen parasitären Strahler repräsentiert. Es wird ein lineares Gleichungssystem mit einer entsprechenden Anzahl an Koeffizienten erzeugt. Anschließend werden aus dem linearen Gleichungssystem die Strahlungsamplituden des direkten Signalanteils der Testantenne und/oder des den indirekten Signalanteil repräsentierenden Signals der parasitären Strahler bestimmt. Diese Verfahrensschritte werden durch das eingangs erwähnte Mittel der Anordnung ausgeführt. Dabei erfolgt die Bestimmung der Koeffizienten unter Berücksichtigung der geometrischen Anordnung von Testantenne, der Mehrzahl an Messsonden und der parasitären Strahler und einer angenommenen Fernfeldausbreitung. Dabei wird zweckmäßigerweise von den Gesetzen der Strahloptik ausgegangen.

Auch die Bestimmung der Koeffizienten unter Berücksichtigung der geometrischen Anordnung der beteiligten Komponenten erfolgt unter Ausführung des entsprechend dazu ausgebildeten Mittels der erfindungsgemäßen Anordnung.

Die mehreren Messsonden sind bezüglich einer parallel zu der Bezugsebene angeordneten Symmetrieebene, in welcher die Testantenne liegt, symmetrisch angeordnet. Es ist weiterhin zweckmäßig, wenn die mehreren Messsonden in einer Ebene übereinander angeordnet werden, welche zu der Bezugsebene senkrecht orientiert ist. Wie bereits erläutert, werden die parasitären Strahler zwischen der Testantenne und den Messsonden verteilt angeordnet. Die Lösung des aus den Messwerten erzeugten Gleichungssystems liefert neben den Strahlungsamplituden der parasitären Strahler die gesuchte Strahlungsamplitude des direkten Signalanteils der Testantenne.

Es ist weiterhin vorteilhaft, wenn der Winkelbereich, unter dem die Messsonden zu der Testantenne angeordnet sind, derart gewählt ist, dass das Richtdiagramm innerhalb des Winkelbereichs innerhalb einer vorgegebenen Schwenkungsbreite konstant ist. In der Regel ist diese Voraussetzung bei Freifeldmessanlagen mit einem großen Abstand zwischen Testantenne und den Messsonden hinreichend gut erfüllt.

Sofern die Wahl des Winkelbereichs, unter dem die Messsonden zu der Testantenne angeordnet sind, nicht derart ist, dass die Strahlungsamplitude innerhalb des Winkelbereichs innerhalb einer vorgegebenen Schwankungsbreite konstant ist, kann vorgesehen sein, dass ein Gleichungssystem für einen insbesondere kompletten Schnitt durch das Antennendiagramm der Testantenne erzeugt und gelöst wird, in dem die Änderungen des Antennendiagramms innerhalb des Winkelbereichs zu den Messsonden berücksichtigt werden.

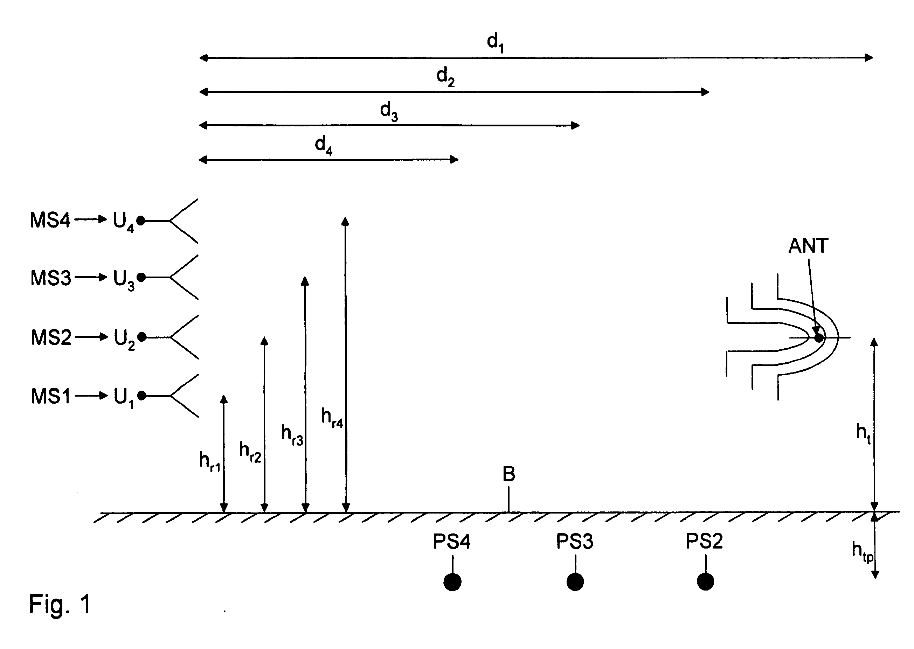

Die Erfindung wird nachfolgend anhand eines Ausführungsbeispiels erläutert. Die einzige Figur zeigt eine erfindungsgemäße Anordnung zur Fernfeldmessung eines Freiraum-Antennendiagramms.

Eine zu testende Antenne ANT, nachfolgend als Testantenne bezeichnet, ist in einer Höhe hₜ über einer Bezugsebene B angeordnet. Die Bezugsebene B ist beispielsweise durch eine ebene Bodenfläche repräsentiert, wobei jedoch auch Bodenunebenheiten erlaubt sind. In einem Abstand d₁ von der Testantenne ANT sind beispielhaft vier in senkrechter Richtung zur Bezugsebene B angeordnete Messsonden MS1, MS2, MS3, MS4 übereinander vorgesehen. Die Messsonde MS1 ist hierbei in einer Höhe hᵣ₁ über der Bezugsebene B angeordnet. Die Messsonde MS2 ist in einer Höhe hᵣ₂ über der Bezugsebene B angeordnet. In entsprechender Weise sind die Messsonden MS3, MS4 in einer Höhe hᵣ₃ bzw. hᵣ₄ über der Bezugsebene B angeordnet. Die Messsonden MS1, MS2, MS3, MS4 sind hierbei beispielhaft bezüglich einer parallel zu der Bezugsebene angeordneten Symmetrieebene, in welcher die Testantenne ANT liegt, symmetrisch angeordnet. Dies bedeutet: (hᵣ₁+hᵣ₄)/2 = (hᵣ₂+hᵣ₃)/2 = hₜ.

Zwischen der Testantenne ANT und den Messsonden MS1, MS2, MS3, MS4 dienen parasitäre Strahler PS2, PS3, PS4 als Repräsentanten für am Boden entstehende Streufeldanteile des Messsignals. Die parasitären Strahler PS2, PS3, PS4 werden für das weitere Vorgehen als in einem bekannten Abstand hₜₚ unterhalb der Bezugsebene B angenommen. Die parasitären Strahler PS2, PS3 und PS4 werden ferner in einem bekannten Abstand d₂, d₃ und d₄ zu den Messsonden MS1, MS2, MS3 und MS4 angenommen.

Das erfindungsgemäße Vorgehen basiert auf einem parametrischen Modell, auf dessen Grundlage die Streufeldanteile durch den Boden unterdrückt bzw. eliminiert werden können. Hierzu wird unter Verwendung aller Messsonden MS1, MS2, MS3, MS4 eine Messung des Übertragungsverhaltens zur Testantenne vorgenommen. Dies ist in der Figur durch jeweilige Spannungswerte U₁, U₂, U₃, U₄ repräsentiert. Die am Boden gestreuten Signalanteile werden durch die angenommenen parasitären Strahler PS2, PS3, PS4 mit jeweils unbekannter Strahlungsamplitude und Phase repräsentiert. Durch die Messung mit den Messsonden MS1, MS2, MS3, MS4 werden die sich zeitlich ändernden, jeweils vorherrschenden Streueigenschaften des Bodens berücksichtigt.

Das Vorgehen basiert somit darauf, parasitäre Strahler an bekannten Positionen unterhalb der Bezugsebene B anzunehmen, deren Strahlungsamplitude und Phase unbekannt ist. Sinnbildlich kann nach Einführung der parasitären Strahler Boden entfernt werden, da der Streubeitrag nun von den Parasitären Strahlern PS2, PS3, PS4 geleistet wird. Zweckmäßig ist es hierzu, dass die Testantenne ANT nicht wesentlich mit dem Boden verkoppelt ist, was durch eine ausreichend große Höhe hₜ sichergestellt werden kann.

Im Ausführungsbeispiel wurden beispielhaft n = 3 parasitäre Strahler PS2, PS3, PS4 angenommen, wobei die Anzahl der parasitären Strahler prinzipiell auch anders gewählt werden kann. Das Gesamtfeld setzt sich somit zusammen aus dem Freiraumfeld der sendenden Antenne und den Beiträgen der parasitären Strahler PS2, PS3, PS4. Dies bedeutet, dass mindestens n+1 = 3+1 = 4 linear unabhängige Messwerte, d.h. einer für jede der Messsonden MS1, MS2, MS3, MS4 aufgenommen werden müssen, woraus ein lineares Gleichungssystem erzeugt werden kann, das die Bestimmung des Richtdiagrammwertes der Testantenne ANT und der Strahlungsamplituden der drei parasitären Strahler PS2, PS3, PS4 erlaubt.

Die Bestimmung der Koeffizienten des Gleichungssystems kann anhand der bekannten Geometriedaten (es sind die Höhe hₜ der Antenne ANT über der Bezugsebene B, die Höhen hᵣ₁, hᵣ₂, hᵣ₃, hᵣ₄ der jeweiligen Messsonden MS1, MS2, MS3 über der Bezugsebene B, der Abstand d₁ zwischen der Testantenne ANT und den Messsonden MS1, MS2, MS3, MS4, sowie die Abstände d₂, d₃, d₄ zwischen den parasitären Strahlern PS2, PS3, PS4 und den Messsonden MS1, MS2, MS3, MS4 bekannt) unter Annahme einer Fernfeldausbreitung und Anwendung der aus der Strahlenoptik bekannten Gesetze erfolgen. Die Bestimmung der Koeffizienten des Gleichungssystems kann auch mit aufwändigeren Berechnungsmethoden erfolgen.

Die Lösung des Gleichungssystems liefert neben den Strahlungsamplituden der parasitären Strahler PS2, PS3, PS4 den gesuchten Richtdiagrammwert der Testantenne ANT in Richtung zu den Messsonden MS1, MS2, MS3, MS4. Hierbei wird angenommen, dass die Winkeldifferenz, unter der die Testantenne ANT die einzelnen Messsonden MS1, MS2, MS3, MS4 sieht, so klein ist, dass sich das Richtdiagramm der Testantenne ANT in diesem Winkelbereich nicht ändert.

Falls diese Annahme nicht gilt, kann ein vollständiger Schnitt des Antennendiagramms betrachtet werden und ein Gleichungssystem für alle betrachteten Abtastpunkte des Schnittes betrachtet werden.

Die Kosten für die Implementierung des Verfahrens sind gering. Dabei wird ein hohes Nutzen-zu-Kosten-Verhältnis erreicht. Insbesondere ist das Vorgehen weitgehend unabhängig von der Messbandbreite im Vergleich zu den aus dem Stand der Technik bekannten Methoden, die oft nur für sehr große oder sehr kleine Messbandbreiten ausreichend genau arbeiten.

### Bezugszeichenliste

- ANT: Testantenne
- MS1: Messsonde
- MS2: Messsonde
- MS3: Messsonde
- MS4: Messsonde
- PS2: parasitärer Strahler
- PS3: parasitärer Strahler
- PS4: parasitärer Strahler
- B: Bezugsebene
- hₜ: Höhe
- hᵣ₁: Höhe
- hᵣ₂: Höhe
- hᵣ₃: Höhe
- hᵣ₄: Höhe
- hₜₚ: Höhe
- d₁: Abstand zwischen Testantenne und Messsonden
- d₂: Abstand zwischen parasitärem Strahler und Messsonden
- d₃: Abstand zwischen parasitärem Strahler und Messsonden
- d₄: Abstand zwischen parasitärem Strahler und Messsonden
- U₁: Spannung
- U₂: Spannung
- U₃: Spannung
- U₄: Spannung

## Patentansprüche

1. Verfahren zur Vermessung des Richtdiagramms einer Testantenne (ANT), bei dem
- mehrere Messsonden (MS1, .., MS4) relativ zu der Testantenne (ANT) angeordnet werden;
- die Testantenne (ANT) in einer vorgegebenen Höhe (hₜ) über einer Bezugsebene (B), insbesondere einem Erdboden, und die mehreren Messsonden (MS1, .., MS4) jeweils in einer vorgegebenen Höhe (hᵣ₁, .., hᵣ₄) über der Bezugsebene (B) angeordnet werden;
- zwischen allen Messsonden (MS1, .., MS4) und der Testantenne (ANT) eine Messung des Übertragungsverhaltens zur Testantenne (ANT) vorgenommen wird; und
- das zur jeweiligen Messzeit vorherrschende Streuverhalten der Bezugsebene ermittelt und bei der Vermessung des Richtdiagramms der Testantenne (ANT) berücksichtigt wird;
**dadurch gekennzeichnet, dass**
- die mehreren Messsonden (MS1, .., MS4) bezüglich einer parallel zu der Bezugsebene (B) angeordneten Symmetrieebene, in welcher die Testantenne (ANT) liegt, symmetrisch angeordnet werden; und
- die an der Bezugsebene gestreuten Signalanteile hinsichtlich der Signalamplitude unterdrückt werden, wobei die Signalamplituden durch ein parametrisches Modell aus den Messwerten der mehreren Messsonden ermittelt werden.

2. Verfahren nach Anspruch 1, bei dem zur rechnergestützten Ermittlung der Streueigenschaften der Bezugsebene als Repräsentant der Bezugsebene ein oder mehrere parasitäre Strahler (PS2, PS3, PS4) mit jeweils unbekannter Strahlungsamplitude und Phase angenommen werden.

3. Verfahren nach Anspruch 2, bei dem
- n+1 linear unabhängige Messwerte entsprechend n+1 Messsonden (MS1, ... MS4) aufgenommen werden, wobei n die Anzahl der angenommenen parasitären Strahler (PS2, PS3, PS4) repräsentiert;
- ein lineares Gleichungssystem mit einer entsprechenden Anzahl an Koeffizienten erzeugt wird; und
- aus dem linearen Gleichungssystem der Richtdiagrammwert der Testantenne (ANT) und die Strahlungsamplituden und Phasen der Strahler (PS2, PS3, PS4) bestimmt werden.

4. Verfahren nach Anspruch 3, bei dem die Bestimmung der Koeffizienten unter Berücksichtigung der geometrischen Anordnung von Testantenne (ANT), der Mehrzahl an Messsonden (MS1, .., MS4) und der parasitären Strahler (PS2, PS3, PS4) und einer angenommenen Fernfeldausbreitung erfolgt.

5. Verfahren nach einem der vorherigen Ansprüche, bei dem die mehreren Messsonden (MS1, .., MS4) in einer Ebene übereinander angeordnet werden, welche zu der Bezugsebene (B) senkrecht orientiert ist.

6. Verfahren nach einem der vorherigen Ansprüche, bei dem die parasitären Strahler (PS2, PS3, PS4) zwischen der Testantenne (ANT) und den Messsonden (MS1, .., MS4) verteilt angeordnet werden.

7. Verfahren nach einem der vorherigen Ansprüche, bei dem der Winkelbereich, unter dem die Messsonden (MS1, .., MS4) zur Testantenne (ANT) angeordnet sind, derart gewählt ist, dass das Richtdiagramm innerhalb des Winkelbereichs innerhalb einer vorgegebenen Schwankungsbreite konstant ist.

8. Verfahren nach einem der Ansprüche 1 bis 6, bei dem
- ein Gleichungssystem für einen insbesondere kompletten Schnitt durch das Antennendiagramm der Testantenne erzeugt wird;
- das Gleichungssystem gelöst wird, indem Änderungen des Antennendiagramms innerhalb des Winkelbereichs zu den Messsonden berücksichtigt werden.

9. Anordnung zur Vermessung des Richtdiagramms einer Testantenne (ANT), umfassend mehrere Testsonden (MS1, .., MS4), die relativ zu der Testantenne (ANT) angeordnet werden, wobei die Testantenne (ANT) in einer vorgegebenen Höhe (hₜ) über einer Bezugsebene (B), insbesondere eines Erdbodens, und die mehreren Messsonden (MS1, .., MS4) jeweils in einer vorgegebenen Höhe (hᵣ₁, .., hᵣ₄) über der Bezugsebene (B) angeordnet sind, und wobei die Anordnung ein Mittel umfasst, welches dazu ausgebildet ist, zwischen allen Messsonden (MS1, .., MS4) und der Testantenne eine Messung des Übertragungsverhaltens zur Testantenne durchzuführen und die zur jeweiligen Messzeit vorherrschenden Streueigenschaften der Bezugsebene zu ermitteln und bei der Vermessung des Richtdiagramms der Testantenne (ANT) zu berücksichtigen,
**dadurch gekennzeichnet, dass**
- die mehreren Messsonden (MS1, .., MS4) bezüglich einer parallel zu der Bezugsebene (B) angeordneten Symmetrieebene, in welcher die Testantenne (ANT) liegt, symmetrisch angeordnet sind, und
- das Mittel dazu ausgebildet ist, die an der Bezugsebene gestreuten Signalanteile hinsichtlich der Signalamplitude, die durch ein parametrisches Modell aus den Messwerten der mehreren Messsonden ermittelt werden, zu unterdrücken.

10. Anordnung nach Anspruch 9, bei dem zur rechnergestützten Ermittlung der Streueigenschaften der Bezugsebene als Repräsentant der Bezugsebene ein oder mehrere parasitäre Strahler (PS2, PS3, PS4) mit jeweils unbekannter Strahlungsamplitude und Phase vorgesehen sind.

11. Anordnung nach einem der Ansprüche 9 oder 10, bei dem die mehreren Messsonden (MS1, .., MS4) in einer Ebene übereinander angeordnet sind, welche zu der Bezugsebene (B) senkrecht orientiert ist.

12. Anordnung nach einem der Ansprüche 9 bis 11, bei dem der Winkelbereich, unter dem die einzelnen Messsonden (MS1, .., MS4) zur Testantenne (ANT) angeordnet sind, derart gewählt ist, dass das Richtdiagramm innerhalb des Winkelbereichs innerhalb einer vorgegebenen Schwankungsbreite konstant ist.

## Claims

1. Method for measuring the radiation pattern of a test antenna (ANT), in which
- a plurality of measuring probes (MS1, .., MS4) are arranged relative to the test antenna (ANT);
- the test antenna (ANT) is arranged at a predefined height (hₜ) above a reference plane (B), in particular the ground, and the plurality of measuring probes (MS1, .., MS4) are each arranged at a predefined height (hᵣ₁, .., hᵣ₄) above the reference plane (B);
- the transmission behaviour to the test antenna (ANT) is measured between all measuring probes (MS1, .., MS4) and the test antenna (ANT); and
- the scattering behaviour of the reference plane prevailing at the respective measuring time is determined and is taken into account when measuring the radiation pattern of the test antenna (ANT);
**characterized in that**
- the plurality of measuring probes (MS1, .., MS4) are arranged symmetrically with respect to a plane of symmetry which is arranged parallel to the reference plane (B) and in which the test antenna (ANT) lies; and
- the signal amplitude of the signal components scattered at the reference plane is suppressed, the signal amplitudes being determined from the measured values from the plurality of measuring probes by means of a parametric model.

2. Method according to Claim 1, in which, in order to determine the scattering properties of the reference plane in a computer-assisted manner, one or more parasitic emitters (PS2, PS3, PS4) each with an unknown radiation amplitude and phase are assumed as the representative of the reference plane.

3. Method according to Claim 2, in which
- n+1 linearly independent measured values corresponding to n+1 measuring probes (MS1, .., MS4) are recorded, where n represents the number of assumed parasitic emitters (PS2, PS3, PS4);
- a linear equation system having a corresponding number of coefficients is generated; and
- the radiation pattern value of the test antenna (ANT) and the radiation amplitudes and phases of the emitters (PS2, PS3, PS4) are determined from the linear equation system.

4. Method according to Claim 3, in which the coefficients are determined taking into account the geometric arrangement of the test antenna (ANT), the plurality of measuring probes (MS1, .., MS4) and the parasitic emitters (PS2, PS3, PS4) and an assumed far field propagation.

5. Method according to one of the preceding claims, in which the plurality of measuring probes (MS1, .., MS4) are arranged above one another in a plane oriented perpendicular to the reference plane (B).

6. Method according to one of the preceding claims, in which the parasitic emitters (PS2, PS3, PS4) are arranged in a distributed manner between the test antenna (ANT) and the measuring probes (MS1, .., MS4).

7. Method according to one of the preceding claims, in which the angular range in which the measuring probes (MS1, .., MS4) are arranged with respect to the test antenna (ANT) is selected in such a manner that the radiation pattern is constant within a predefined fluctuation range within the angular range.

8. Method according to one of Claims 1 to 6, in which
- an equation system is generated for a section, in particular a complete section, through the antenna pattern of the test antenna;
- the equation system is solved by taking into account changes in the antenna pattern within the angular range with respect to the measuring probes.

9. Arrangement for measuring the radiation pattern of a test antenna (ANT), comprising a plurality of test probes (MS1, .., MS4) which are arranged relative to the test antenna (ANT), the test antenna (ANT) being arranged at a predefined height (hₜ) above a reference plane (B), in particular the ground, and the plurality of measuring probes (MS1, .., MS4) each being arranged at a predefined height (hᵣ₁, .., hᵣ₄) above the reference plane (B), and the arrangement comprising a means which is designed to measure the transmission behaviour to the test antenna between all measuring probes (MS1, .., MS4) and the test antenna and to determine the scattering properties of the reference plane prevailing at the respective measuring time and to take them into account when measuring the radiation pattern of the test antenna (ANT),
**characterized in that**
- the plurality of measuring probes (MS1, .., MS4) are arranged symmetrically with respect to a plane of symmetry which is arranged parallel to the reference plane (B) and in which the test antenna (ANT) lies, and
- the means is designed to suppress the signal amplitude of the signal components scattered at the reference plane, which are determined from the measured values from the plurality of measuring probes by means of a parametric model.

10. Arrangement according to Claim 9, in which, in order to determine the scattering properties of the reference plane in a computer-assisted manner, one or more parasitic emitters (PS2, PS3, PS4) each having an unknown radiation amplitude and phase are provided as the representative of the reference plane.

11. Arrangement according to either of Claims 9 and 10, in which the plurality of measuring probes (MS1, .., MS4) are arranged above one another in a plane oriented perpendicular to the reference plane (B).

12. Arrangement according to one of Claims 9 to 11, in which the angular range in which the individual measuring probes (MS1, .., MS4) are arranged with respect to the test antenna (ANT) is selected in such a manner that the radiation pattern is constant within a predefined fluctuation range within the angular range.

## Revendications

1. Procédé de mesurage du diagramme directionnel d'une antenne d'essai (ANT), selon lequel
- plusieurs sondes de mesure (MS1, ..., MS4) sont disposées par rapport à l'antenne d'essai (ANT) ;
- l'antenne d'essai (ANT) est disposée à une hauteur prédéfinie (hₜ) au-dessus d'un plan de référence (B), notamment un terrain, et les plusieurs sondes de mesure (MS1, ..., MS4) sont disposées respectivement à une hauteur prédéfinie (hᵣ₁, ..., hᵣ₄) au-dessus du plan de référence (B) ;
- une mesure du comportement de transmission vers l'antenne d'essai (ANT) est effectuée entre toutes les sondes de mesure (MS1, ..., MS4) et l'antenne d'essai (ANT) ; et
- le comportement de dispersion dominant du plan de référence à l'instant de mesure respectif est déterminé et pris en compte lors du mesurage du diagramme directionnel de l'antenne d'essai (ANT) ;
**caractérisé en ce que**
- les plusieurs sondes de mesure (MS1, ..., MS4) sont disposées de manière symétrique par rapport à un plan de symétrie disposé en parallèle au plan de référence (B) et dans lequel se trouve l'antenne d'essai (ANT) ; et
- les parts de signal dispersées au niveau du plan de référence sont supprimées du point de vue de l'amplitude du signal, les amplitudes de signal étant déterminées par un modèle paramétrique à partir des valeurs mesurées des plusieurs sondes de mesure.

2. Procédé selon la revendication 1, selon lequel un ou plusieurs éléments rayonnants parasites (PS2, PS3, PS4), ayant respectivement une amplitude de rayonnement et une phase inconnues, sont pris pour hypothèse en tant que représentants du plan de référence pour la détermination assistée par ordinateur des propriétés de dispersion du plan de référence.

3. Procédé selon la revendication 2, selon lequel
- n+1 valeurs mesurées indépendantes linéairement correspondant à n+1 sondes de mesure (MS1, ..., MS4) sont collectées, n représentant le nombre d'éléments rayonnants parasites (PS2, PS3, PS4) pris pour hypothèse ;
- un système d'équations linéaire est généré avec un nombre correspondant de coefficients ; et
- la valeur du diagramme directionnel de l'antenne d'essai (ANT) et les amplitudes de rayonnement ainsi que les phases des éléments rayonnants (PS2, PS3, PS4) sont déterminées à partir du système d'équations linéaire.

4. Procédé selon la revendication 3, selon lequel la détermination des coefficients s'effectue en tenant compte de l'arrangement géométrique de l'antenne d'essai (ANT), de la pluralité de sondes de mesure (MS1, ..., MS4) et des éléments rayonnants parasites (PS2, PS3, PS4) ainsi que d'une propagation supposée du champ lointain.

5. Procédé selon l'une des revendications précédentes, selon lequel les plusieurs sondes de mesure (MS1, ..., MS4) sont disposées les unes au-dessus des autres dans un plan qui est orienté perpendiculairement au plan de référence (B).

6. Procédé selon l'une des revendications précédentes, selon lequel les éléments rayonnants parasites (PS2, PS3, PS4) sont disposés répartis entre l'antenne d'essai (ANT) et les sondes de mesure (MS1, ..., MS4).

7. Procédé selon l'une des revendications précédentes, selon lequel la plage d'angles dans laquelle les sondes de mesure (MS1, ..., MS4) sont disposées par rapport à l'antenne d'essai (ANT) est choisie de telle sorte que le diagramme directionnel est constant à l'intérieur de la plage d'angles, dans les limites d'une amplitude de fluctuation prédéfinie.

8. Procédé selon l'une des revendications 1 à 6, selon lequel
- un système d'équations est généré pour une coupe notamment complète à travers le diagramme d'antenne de l'antenne d'essai ;
- le système d'équations est résolu en tenant compte des variations du diagramme d'antenne à l'intérieur de la plage d'angles par rapport aux sondes de mesure.

9. Arrangement de mesurage du diagramme directionnel d'une antenne d'essai (ANT), comprenant plusieurs sondes d'essai (MS1, ..., MS4) qui sont disposées par rapport à l'antenne d'essai (ANT), l'antenne d'essai (ANT) étant disposée à une hauteur prédéfinie (hₜ) au-dessus d'un plan de référence (B), notamment un terrain, et les plusieurs sondes de mesure (MS1, ..., MS4) étant disposées respectivement à une hauteur prédéfinie (hᵣ₁, ..., hᵣ₄) au-dessus du plan de référence (B), et l'arrangement comprenant des moyens qui sont configurés pour effectuer une mesure du comportement de transmission vers l'antenne d'essai entre toutes les sondes de mesure (MS1, ..., MS4) et l'antenne d'essai et pour déterminer les propriétés de dispersion dominantes du plan de référence à l'instant de mesure respectif et pour en tenir compte lors du mesurage du diagramme directionnel de l'antenne d'essai (ANT),
**caractérisé en ce que**
- les plusieurs sondes de mesure (MS1, ..., MS4) sont disposées de manière symétrique par rapport à un plan de symétrie disposé en parallèle au plan de référence (B) et dans lequel se trouve l'antenne d'essai (ANT) ; et
- les moyens sont configurés pour supprimer les parts de signal dispersées au niveau du plan de référence du point de vue de l'amplitude du signal, lesquelles parts de signal sont déterminées par un modèle paramétrique à partir des valeurs mesurées des plusieurs sondes de mesure.

10. Arrangement selon la revendication 9, avec lequel un ou plusieurs éléments rayonnants parasites (PS2, PS3, PS4), ayant respectivement une amplitude de rayonnement et une phase inconnues, sont prévus en tant que représentants du plan de référence pour la détermination assistée par ordinateur des propriétés de dispersion du plan de référence.

11. Arrangement selon l'une des revendications 9 ou 10, avec lequel les plusieurs sondes de mesure (MS1, ..., MS4) sont disposées les unes au-dessus des autres dans un plan qui est orienté perpendiculairement au plan de référence (B).

12. Arrangement selon l'une des revendications 9 à 11, avec lequel la plage d'angles dans laquelle les sondes de mesure (MS1, ..., MS4) individuelles sont disposées par rapport à l'antenne d'essai (ANT) est choisie de telle sorte que le diagramme directionnel est constant à l'intérieur de la plage d'angles, dans les limites d'une amplitude de fluctuation prédéfinie.
